# EUROPEAN PATENT SPECIFICATION

(11) **EP 2 833 395 B1**
(45) Date of publication and mention of the grant of the patent: **01.05.2019**
(21) Application number: 12872525.6
(22) Date of filing: 27.03.2012
(51) Int. Cl.: H01L 21/67, H01L 21/52, H05K 13/02, H01L 21/677, H01L 21/68

(54) **DIE SUPPLY DEVICE**
CHIPZUFUHRVORRICHTUNG
DISPOSITIF DE FOURNITURE DE PUCE

(43) Date of publication of application: 04.02.2015
(73) Proprietor: FUJI Corporation, Chiryu Aichi (JP)
(72) Inventor: HOSAKA, Hideki, Chiryu, Aichi (JP); IWASE, Tomonori, Chiryu, Aichi (JP); KOMIYAMA, Nobuhisa, Chiryu, Aichi (JP); TSUGE, Kuniaki, Chiryu, Aichi (JP)
(74) Representative: Grünecker Patent- und Rechtsanwälte PartG mbB
(86) International application number: PCT/JP2012/057863
(87) International publication number: WO 2013/145114

(56) References cited:
- WO-A1-2011/128981
- WO-A1-2011/128981
- JP-A- H0 917 841
- JP-A- 2005 032 827
- JP-A- 2006 332 417
- JP-A- 2010 129 949
- US-A- 5 851 848

## Description

The present invention relates to a die supply device comprising an expanded wafer body stretched across which is a stretchable dicing sheet on which is affixed a wafer which has been diced to be divided into multiple dies, and a suction nozzle for picking up a die on the dicing sheet.

In recent years, as disclosed in JP 2010 129949 A, there are items for setting die supply devices which supply dies onto component mounters and mounting the dies onto circuit boards using component mounters. This die supply device comprises a wafer pallet stretched across which is a stretchable dicing sheet on which is affixed a wafer which has been diced to be divided into multiple dies, and a pusher pin arranged below the dicing sheet, so that when pickup is performed by lowering a suction nozzle and picking up a die on the dicing sheet, the adhesive section of the die on the dicing sheet which is being attempted to be picked up is raised by the pusher pin so that pickup is performed by picking up the die from the dicing sheet with the suction nozzle while partially separating the die adhesive section from the dicing sheet.

In this case, because the dicing sheet is expanded uniformly in the XY directions in order to create a gap between each die so that pickup becomes easier, the position of each die on the dicing sheet varies based on the expansion amount of the dicing sheet. Due to this, on the die supply device, a camera for performing image recognition of the position of the die is equipped, and before picking up a die on the dicing sheet, a die to be picked up is captured by the camera from above and the position of the die is recognized, and then die pushup movement and pickup movement are performed.

US 5 851 848 A relates to a method for relative positioning a die on a wafer table with respect to a die pickup device after cutting a wafer into dies. The wafer table moves the wafer via an adjuster to locate the next die under program control of a processor so that a robot arm picks up the die from the wafer and places it on a pad of a lead frame. After the table is moved to one good die the align system takes over for good alignment initiated by the processor. The align system provides an align correction signal to align the die accurately and is coupled to the processor.

In JP 2005 32827 A, in consideration of the fact that a wafer includes bad dies, bad dies are recognized by capturing an image of the entire wafer by an overall camera, and pickup movement is performed by performing image processing of the position of good dies with an individual camera, this being performed for good dies only, without image processing being performed for bad dies.

In JP 2005 32827 A, image processing is not performed for bad dies and image processing is performed only for good dies, however, because the number of bad dies is much smaller than the number of good dies, by only omitting image processing for bad dies, the effect of shortening the total processing time for captured images per wafer is small and effect of shortening the die supply time per wafer is small.

Therefore, the object of the present invention is a die supply device which is capable of increasing the effects of shortening the total processing time for captured images per wafer and increasing the effects of shortening the die supply time per wafer.

### Means for Solving the Problem

To solve the above problem, the present invention is a die supply device comprising an expanded wafer body stretched across which is a stretchable dicing sheet on which is affixed a wafer which has been diced to be divided into multiple dies, a suction nozzle for picking up a die on the dicing sheet, a pusher mechanism for raising and lowering a pusher pin arranged below the dicing sheet, which, when performing pickup by lowering the suction nozzle and picking up the die on the dicing sheet, is adapted to raise the adhesive section of the die on the dicing sheet which is being attempted to be picked up using the pusher pin to separate the die adhesive section from the dicing sheet in order to pick up the die from the dicing sheet with the suction nozzle, and
an image processing means which is adapted to recognize the position of the die by processing images obtained by taking images of the die on the dicing sheet with a camera,
wherein image-dies to be captured by the camera are specified as every other die or every several dies from among dies on the dicing sheet, wherein for image-dies, the image processing means is adapted to recognize the positions of the image-die, and the pushup mechanism is adapted to then perform pushup movement and pickup movement of the image-die, and
wherein for non-image-dies not to be captured by the camera, the image processing means is adapted to estimate the position of the non-image-die with reference to the recognized position of the image-die, and the pushup mechanism is adapted to then perform pushup movement and pickup movement of the non-image-die.

Generally, by using product specifications provided from a manufacturer of an expanded wafer body (for example wafer size, die size, space between dies, die arrangement information, and so on), positions of each die on a dicing sheet can be estimated, however, errors arise with the estimated position of a die due to variations in products (variations in dicing sheet expansion, wafer XY-direction tilt and so on). Further, even when the pickup position or pushup position of a die deviates a little, if the deviation amount is small, it is sufficiently possible to pick up the die.

In consideration of these circumstances, in the present invention, image-dies to be captured by a camera are specified every other piece or every several pieces intermittently; and, for an image-die, the position of the image-die is recognized by an image processing means and then pushup movement and pickup movement of the image-die are performed; and, for a non-image-die which is not captured by a camera, the position of the non-image-die is estimated with reference to the position of the image-die, and then pushup movement and pickup movement of the non-image-dies are performed. By doing this, because the number of dies which is captured by a camera can be reduced to half or fewer than the total number of dies on a dicing sheet, the total processing time for captured images per wafer can be drastically reduced and the effect of shortening the die supply time per wafer can be increased. Further, for a non-image-die, because the position of the non-image-die is estimated with reference to the position of a recognized position of an image-die, estimate errors of the position of non-image-dies can be made smaller, and pushup movement and pickup movement of non-image-dies can be also performed stably.

Generally, because bad dies are included among dies on a dicing sheet, wafer mapping data (also referred to as wafer map data) which indicates good or bad for dies on a dicing sheet are often provided by a manufacturer. In this case, it is acceptable to determine good dies and bad dies based on wafer mapping data and to perform pushup movement and pickup movement only for good dies.

In this case, for bad dies, it is acceptable to not perform image processing for all the bad dies, however, if bad dies are lined up continuously, when the number of bad dies continuously lined up is large, the distance to the next good die becomes long, therefore, accordingly an estimate error of the position of a die of which the image is to be captured next becomes large, thereby, there is a possibility that the position of a wrong die is incorrectly determined as the next good die when the next good die is captured by a camera.

As a countermeasure to this, it is acceptable that, for bad dies pushup movement and pickup movement are not performed, but when bad dies are continuously lined up greater or equal to a specified quantity, images of the bad dies are captured by a camera every other piece or every several pieces, positions of the bad dies are recognized by an image processing means, the position of the next die (bad die or good die) to be captured is estimated with reference to the position of the bad die, and the position of the die is recognized by the image processing means by capturing the estimated position of the die as a target position to be captured by the camera when capturing the image of the next die. By doing this, even when the distance to the good die to be captured next is long due to many bad dies being lined up continuously, by repeating the process in which bad dies are captured by a camera every other piece or every several pieces and then the position of the bad die (or good die) to be captured next is estimated with reference to the recognized position of the bad die, it is possible to make the estimate error of the position of the good die which is to be captured next small, thereby it can be prevented that a die in the wrong position is incorrectly determined as a good die.

FIG. 1 is an exterior perspective view of the die supply device from an embodiment of the present invention.
FIG. 2 is an exterior perspective view of the pusher unit and the surrounding sections.
FIG. 3 is an exterior perspective view of the wafer pallet.
FIG. 4 is an enlarged sectional cross section diagram showing the pusher pot raised to the holding position during pusher movement.
FIG. 5 is an enlarged sectional cross section diagram showing the pusher pin protruding from the pusher pot during pusher movement.
FIG. 6 is a diagram to illustrate the positional relationship among image-dies, non-image-dies, and bad dies.
FIG. 7 is a diagram to illustrate the positional relationship among image-dies, non-image-dies, and bad dies when dies are not aligned.

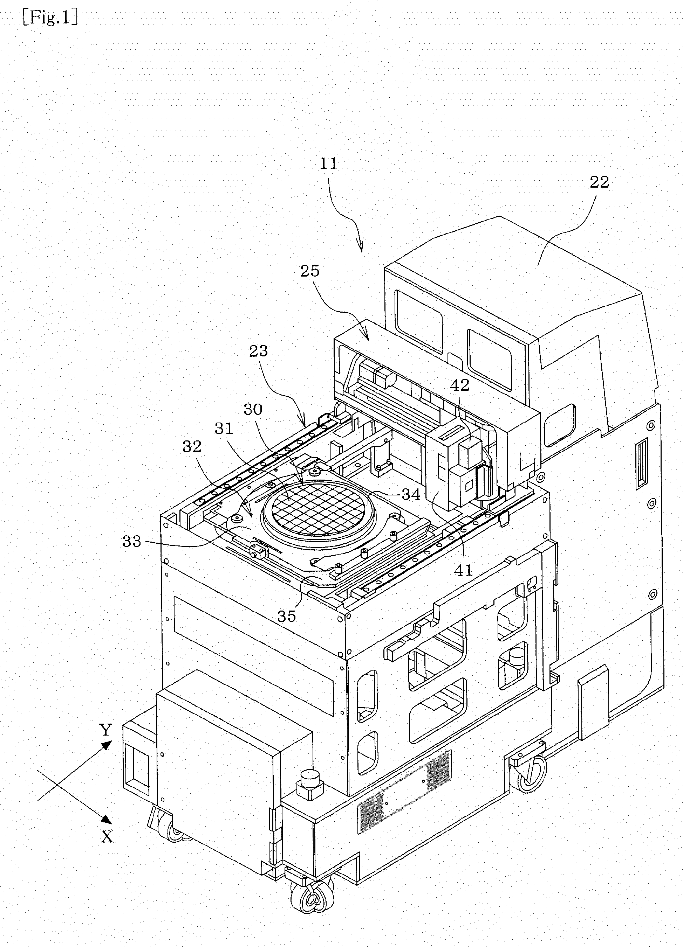

The following describes a specific embodiment for carrying out the present invention. First, the configuration of die supply device 11 is described in summary using FIG. 1.

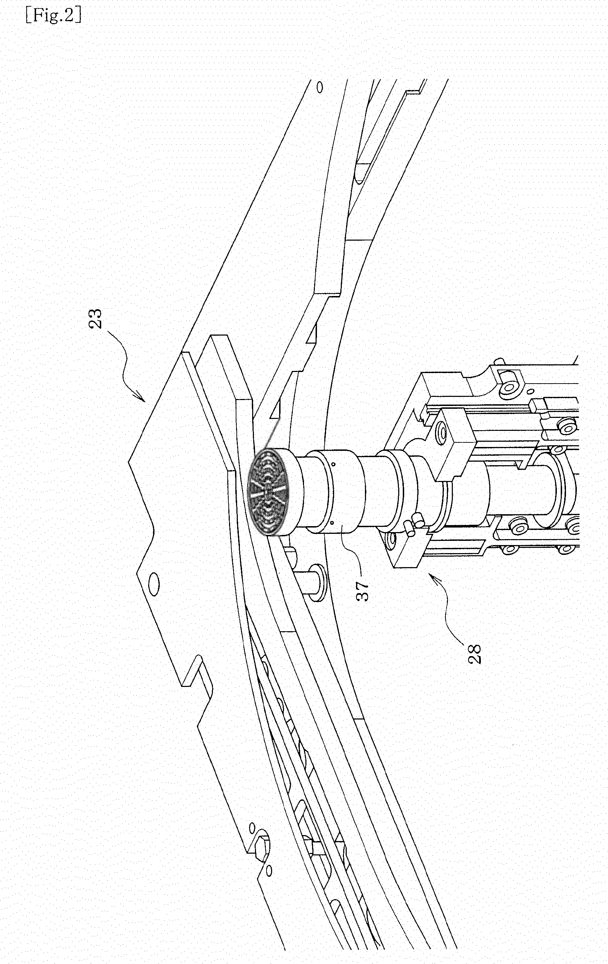

Die supply device 11 comprises magazine holding section 22 (tray tower), pallet withdrawal table 23, XY moving mechanism 25, and pusher unit 28 (refer to FIG. 2) and so on, and is set in a state with pallet withdrawal table 23 inserted into component mounter (not shown).

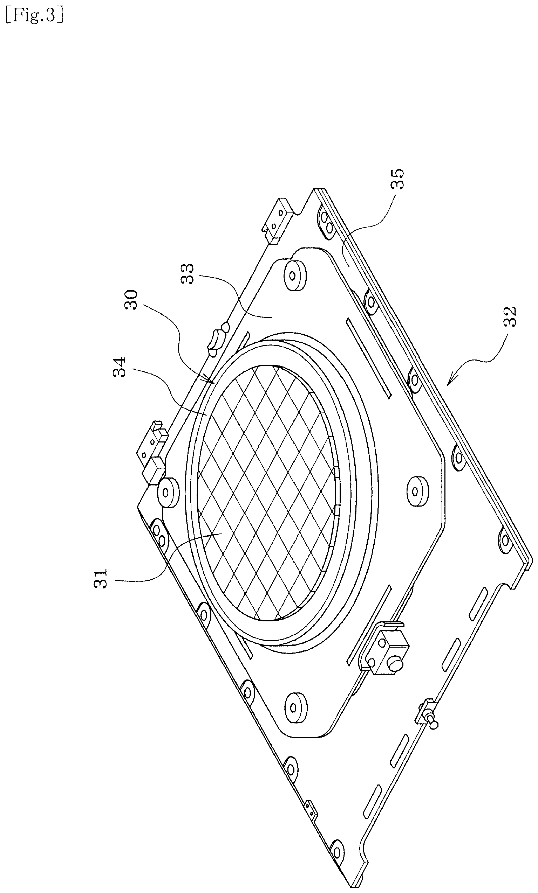

In the magazine (not shown) stored while capable of being moved up and down in magazine holding section 22 of die supply device 11, wafer pallets 32 placed with expanded wafer body 30 are loaded in multiple layers, such that wafer pallets 32 can be withdrawn from the magazine onto pallet withdrawal table 23 during production. As shown in FIG. 3, expanded wafer body 30 is configured such that stretchable dicing sheet 34 affixed with dies 31 formed by a wafer having been diced into a grid-like pattern is mounted in an expanded state onto wafer affixing plate 33 which has a round aperture, and wafer affixing plate 33 is attached to pallet body 35 by items such as screws.

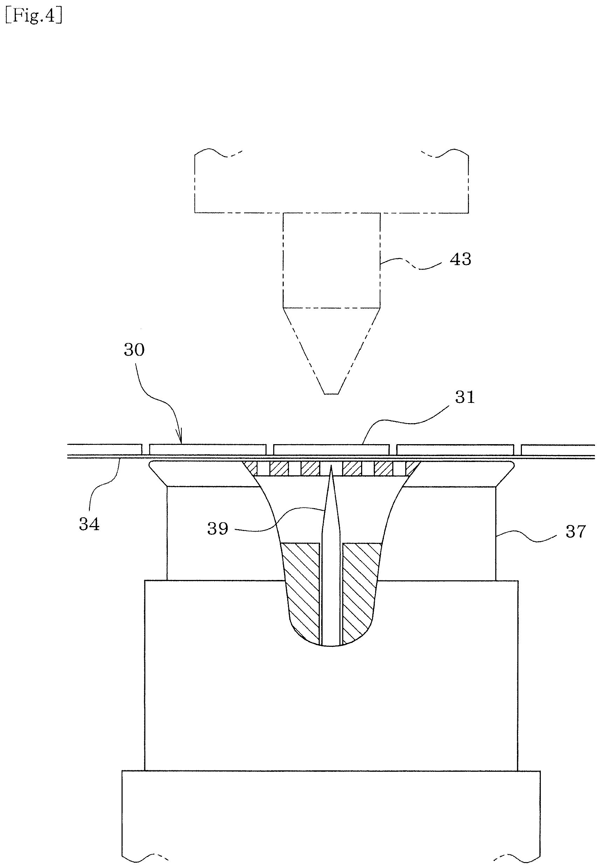

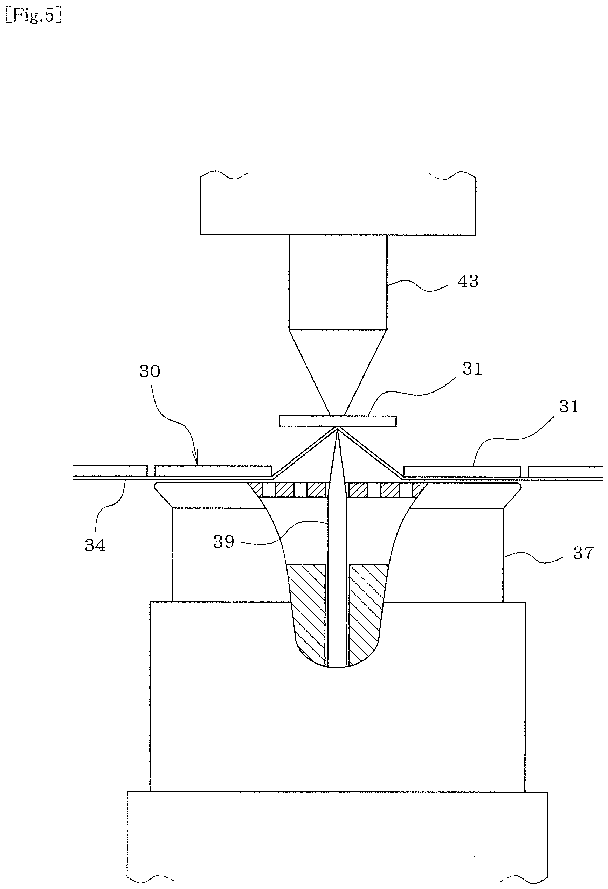

Pusher unit 28 (refer to FIG. 2) is configured to be capable of being moved in the XY direction in the space below dicing sheet 34 of wafer pallet 32. Further, by locally pushing up the adhesive section of die 31 on dicing sheet 34 for which pickup (picking up) is being attempted from below with pusher pin 39 (refer to FIG. 4 and FIG. 5) of pusher pot 37, the adhesive section of the die 31 is partially separated from dicing sheet 34 and is raised up so die 31 is in a state in which pickup is easy.

This pusher unit 28 is configured so that the entire pusher unit 28 moves up and down with a servo motor (not shown) as the source of the driving force. During die pickup movement, when pusher unit 28 is raised so that the upper surface of pusher pot 37 is raised to a specified sheet holding position at which it almost contacts dicing sheet 34 of wafer pallet 32, the raising of pusher unit 28 is stopped by a stopper mechanism (not shown), and when raising movement is continued further, pusher pin 39 (refer to FIG. 4 and FIG. 5) is protruded up from the upper surface of pusher pot 37 so that the adhesive section of die 31 on dicing sheet 34 which is being attempted to be picked up is pushed up. In this case, the pusher height position (pusher amount) of pusher pin 39 can be adjusted by adjusting the turning amount of the servo motor which is the source of the driving force.

As shown in FIG. 1, the configuration is such that pickup head 41 and camera 42 are assembled on XY moving mechanism 25, with pickup head 41 and camera 42 being moved together in the XY direction by the XY moving mechanism 25. Suction nozzle 43 (refer to FIG. 4 and FIG. 5) for picking up die 31 on dicing sheet 34 is provided on pickup head 41 such that it can be moved up and down. Camera 42 is such that the position of die 31 which is attempted to be picked up by suction nozzle 43 can be recognized by capturing an image of die 31 on dicing sheet 34 from above and image processing the captured image.

A control device (not shown) of die supply 11 functions as an image processing means mentioned in the claims, and among dies 31 on dicing sheet 34, for die 31 which is being attempted to be picked up, the position of die 31 is recognized by processing the image captured by camera 42, then the pushup position and pickup position of die 31 are determined, then, as shown in FIG. 5, by locally pushing up the adhesive section of die 31 on dicing sheet 34 for which pickup is being attempted from below with pusher pin 39 of pusher pot 37, while the adhesive section of die 31 is partially separated from dicing sheet 34 and is raised up so die 31 is in a state in which pickup is easy, pickup is performed by picking up die 31 with suction nozzle 43.

Incidentally, by using product specifications provided from a manufacturer of an expanded wafer body 30 (for example wafer size, size of die 31, space between dies 31, arrangement information of dies 31, and so on), positions of each die 31 on a dicing sheet 34 can be estimated, however, errors arise with the estimated position of a die 31 due to variations in products (variations in dicing sheet expansion, wafer XY-direction tilt and so on). Further, even when the pickup position or pushup position of a die 31 deviates a little, if the deviation amount is small, it is sufficiently possible to pick up die 31.

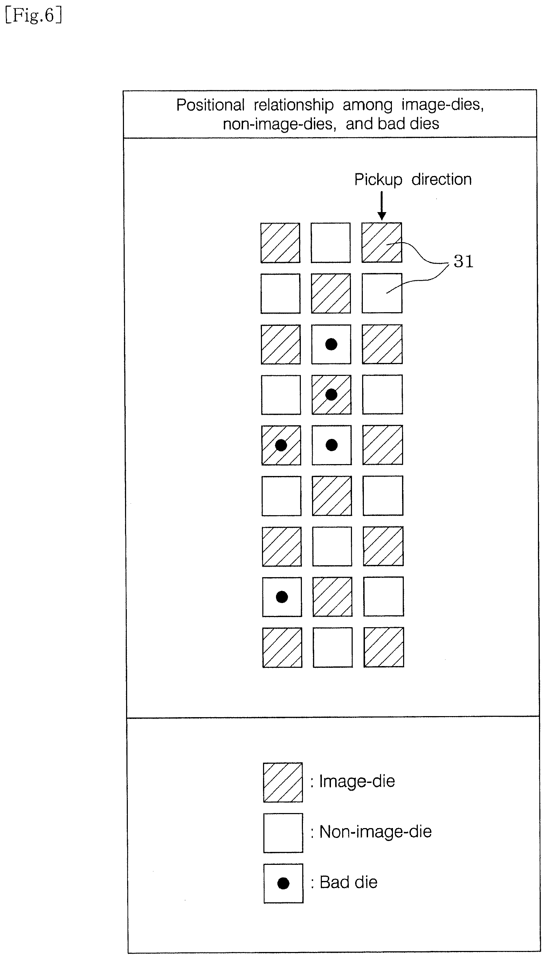

In consideration of these circumstances, in the embodiment, as shown in FIG. 6, among dies 31 on dicing sheet 34, dies 31 which are captured by camera 42 (hereafter referred to as "image-die"), for example, are specified every other piece (or every several pieces) intermittently; and for an image-die, the position of the image-die is recognized by image processing and then pushup movement and pickup movement of the image-die are performed; and for die 31 which is not captured by camera 42 (hereafter referred to as "non-image-die"), the position of the non-image-die is estimated with reference to the recognized position of the adjacent image-die of which image was captured last time, and then pushup movement and pickup movement of the non-image-die is performed.

Here, for a method to estimate the position of a non-image-die with reference to the recognized position of an adjacent image-die of which an image was captured last time, it is acceptable to geometrically calculate it by using the recognized position of the image-die of which an image was captured last time and the following information (a) to (d) and so on.

(a) The number of dies 31 from the image-die of which an image was captured last time to the target non-image-die
(b) Size of die 31
(c) Space between adjacent dies 31
(d) Tilt in XY direction of a wafer (tilt of array of dies 31)

As in the embodiment, if the position of a non-image-die is estimated with reference to the recognized position of an adjacent image-die of which an image was captured last time, the number of dies 31 captured by camera 42 can be reduced to half or fewer than the total number of dies 31 on a dicing sheet 34, thereby the total processing time for captured images per wafer can be drastically reduced and the effect of shortening the die supply time per wafer can be increased. Further, by estimating the position of a non-image-die with reference to the recognized position of an adjacent image-die of which an image was captured last time, estimate errors of the position of non-image-dies can be made smaller, and pushup movement and pickup movement of non-image-dies can also be performed stably.

Generally, because bad dies are included among dies 31 on a dicing sheet 34, wafer mapping data which indicates good or bad for dies 31 on a dicing sheet 34 are often provided by a manufacturer. Therefore, in the embodiment, good dies and bad dies are determined based on wafer mapping data, then pushup movement and pickup movement are performed only for good dies.

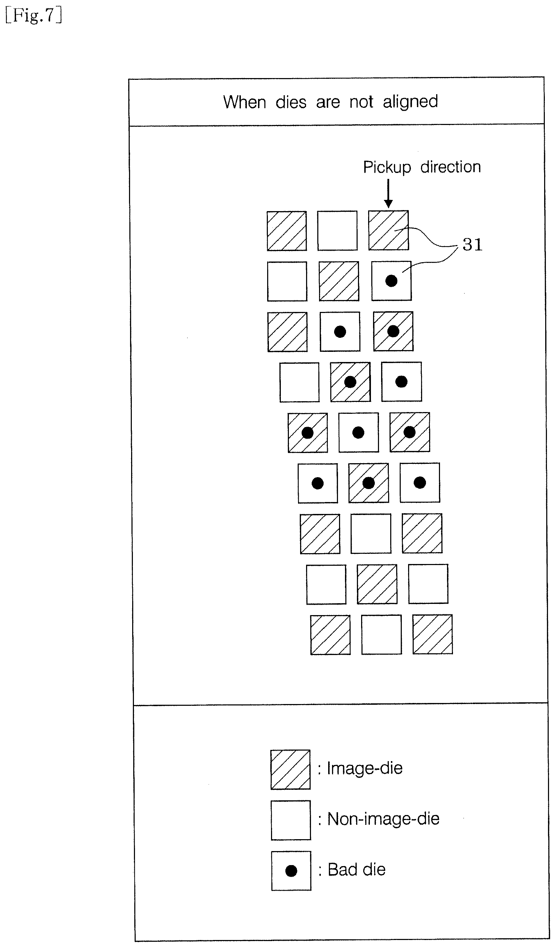

In this case, for bad dies, it is acceptable to not perform image processing for all the bad dies, however, if bad dies are lined up continuously, when the number of bad dies continuously lined up is large, the distance to the next good die becomes long. Therefore, as shown in FIG. 7, when dies 31 are not aligned in a line, if the distance to a good die to be captured next is long, an estimation error of the position of the good die to be captured next becomes large. Due to this, when the next good die is captured by a camera, there is a possibility that die 31 in a wrong position is incorrectly determined as the next good die.

As a countermeasure to this, in the embodiment, for bad dies, pushup movement and pickup movement are not performed, but when bad dies are continuously lined up greater or equal to a specified quantity (for example two pieces or more or three pieces or more), images of the bad dies are captured by a camera 42 every other piece (or every several pieces), positions of the bad dies are recognized by image processing, the position of the next die 31 (bad die or good die) to be captured is estimated with reference to the position of the bad die, and the position of the die 31 is recognized by image processing by capturing the estimated position of the die 31 as a target position to be captured by camera 42 when capturing the image of the next die 31.

By doing this, even when the distance to the good die to be captured next is long due to many bad dies being lined up continuously, by repeating the process in which bad dies are captured by a camera 42 every other piece (or every several pieces) and then the position of the bad die (or good die) to be captured next is estimated with reference to the recognized position of the bad die, it is possible to make the estimate error of the position of the good die which is to be captured next small, thereby it can be prevented that die 31 in the wrong position is incorrectly determined as a good die.

Further, in the embodiment, when estimating the position of a non-image-die, as the recognized position of an image-die adjacent to the non-image-die, the position of the non-image-die is estimated by using the recognized position of an image-die of which an image was captured last time, but it is also acceptable to store the recognized position of a die on a dicing sheet which has been picked up; and, when the die closest to the non-image-die of which the position is to be estimated has been already picked up, to estimate the position of the next die to be captured with reference to the recognized position of the already picked up die.

Also, in the embodiment, the imaging interval for good dies and the imaging interval for bad dies is specified the same, but it is also acceptable to specify the imaging interval for bad dies longer than the imaging interval for good dies.

Also, in the embodiment, both good dies and bad dies are captured by camera 42 intermittently and positions of the dies are recognized, but for example, it is acceptable that: when the required accuracy of the pickup position and pushup position of a good die is not satisfied when images are captured intermittently because the tolerance of the pickup position and pushup position for a good die is small, for good dies images of all the good dies are captured by camera 42 and the position of the die is recognized, and for bad dies, when bad dies are continuously lined up greater or equal to a specified quantity (for example two pieces or more or three pieces or more), images of the bad dies are captured intermittently by camera 42, the position of the bad die is recognized by image processing, then the position of the next die (bad die or good die) to be captured is estimated with reference to the position of the bad die, and the position of the die is recognized by image processing by capturing the estimated position of the die as a target position to be captured by camera 42 when capturing the image of the next die.

Also, die supply device 11 of the embodiment was configured such that pickup head 41 and camera 42 move together in the XY direction by XY moving mechanism 25, but it is also acceptable to move the position of die 31 which is to be captured and picked up in the XY direction by wafer pallet 32 moving pallet withdrawal table 23 in the Y direction and pickup head 41 and camera 42 moving only in the X direction.

In addition, it goes without saying that various embodiments with changes that do not extend beyond the scope of the invention are possible such as those with changes to the configuration of die supply device 11 or configuration of wafer pallet 32. The invention is defined by the claims.

11: Die supply device; 22: Magazine holding section; 23: Pallet withdrawal table; 25: XY moving mechanism; 28: Pusher unit; 30: Expanded wafer body; 31: Die; 32: Wafer pallet; 33: Wafer affixing plate; 34: Dicing sheet; 37: Pusher pot; 39: Pusher pin; 41: Pickup head; 42: Camera; 43: Suction nozzle

## Claims

1. A die supply device (11) comprising
an expanded wafer body (30) stretched across a stretchable dicing sheet (34) on which is affixed a wafer which has been diced to be divided into multiple dies (31), and a suction nozzle (43) for picking up a die (31) on the dicing sheet (34),
**characterized by** further comprising
a pusher mechanism (28) for raising and lowering a pusher pin (39) arranged below the dicing sheet (34), which, when performing pickup by lowering the suction nozzle (43) and picking up the die (31) on the dicing sheet (34), is adapted to raise the adhesive section of the die (31) on the dicing sheet (34) which is being attempted to be picked up using the pusher pin (39) to separate the die adhesive section from the dicing sheet (34) in order to pick up the die (31) from the dicing sheet (34) with the suction nozzle (34), and an image processing means which is adapted to recognize the position of the die (31) by processing images obtained by taking images of the die (31) on the dicing sheet (34) with a camera (42), wherein image-dies to be captured by the camera (42) are specified as every other die or every several dies from among dies (31) on the dicing sheet (34), wherein for image-dies, the image processing means is adapted to recognize the positions of the image-die, and the pushup mechanism (28) is adapted to then perform pushup movement and pickup movement of the image-die, and wherein for non-image-dies not to be captured by the camera (42), the image processing means is adapted to estimate the position of the non-image-die with reference to the recognized position of the image-die, and the pushup mechanism (28) is adapted to then perform pushup movement and pickup movement of the non-image-die.

2. The die supply device according to claim 1, **characterized in that,** the image processing means is adapted to determine good dies and bad dies based on wafer mapping data which indicates good or bad for dies (31) on the dicing sheet (34), the pusher mechanism (28) being adapted to then perform pushup movement and pickup movement for good dies and not to perform pushup movement and pickup movement for bad dies, wherein, for a bad die which is the image-die, the image processing means is adapted to recognize the position of the bad die.

3. The die supply device according to claim 1 or claim 2, **characterized in that,** the image processing means is adapted to estimate the position of the next image-die with reference to the position of the image-die every time the position of the image-die is recognized by the image processing means, wherein the image processing means is adapted to recognize the position of the die by capturing the estimated position of the die as a target position to be captured by the camera (42) when capturing the image of the next die.

4. A die supply device according to claim 1, **characterized in that** the image processing means is adapted to determine good dies and bad dies based on wafer mapping data which indicates good or bad for dies (31) on a dicing sheet (34), and to capture images of the bad dies by the camera (42) every other die or every several dies when bad dies are continuously lined up greater or equal to a specified quantity, wherein the image processing means is adapted to recognize positions of the bad dies, to estimate the position of the next die to be captured with reference to the position of the bad die, and to recognize the position of the die by capturing the estimated position of the die as a target position to be captured by the camera (42) when capturing the image of the next die.

## Patentansprüche

1. Vorrichtung (11) zum Zuführen von Chips, die umfasst:
einen ausgedehnten Wafer-Körper (30), der über eine dehnbare Sägefolie (34) gedehnt ist, an der ein Wafer befestigt ist, der gesägt und damit in mehrere Chips (31) unterteilt worden ist, sowie eine Saugdüse (43) zum Aufnehmen eines Chips (31) auf der Sägefolie (34),
**dadurch gekennzeichnet, dass** sie des Weiteren umfasst:
einen Drück-Mechanismus (28) zum Anheben und Absenken eines Drückstempels (39), der unterhalb der Sägefolie (34) angeordnet ist und so eingerichtet ist, dass er beim Durchführen von Aufnahme durch Absenken der Saugdüse (43) und Aufnehmen des Chips (31) auf der Sägefolie (34) den an der Sägefolie (34) haftenden Abschnitt des Chips (31), der aufgenommen werden soll, unter Verwendung des Drückstempels (39) anhebt, um den haftenden Abschnitt von der Sägefolie (34) zu trennen und so den Chip (31) mit der Saugdüse (34) von der Sägefolie (34) aufzunehmen, sowie eine Bildverarbeitungs-Einrichtung, die so eingerichtet ist, dass sie die Position des Chips (31) durch Verarbeiten von Bildern feststellt, die gewonnen werden, in dem Bilder des Chips (31) auf der Sägefolie (34) mit einer Kamera (42) aufgenommen werden, wobei mit der Kamera (42) aufzunehmende Bild-Chips als jeder zweite Chip oder jeweils einer von mehreren Chips von dem Chips (31) auf der Sägefolie (34) bestimmt werden, die Bildverarbeitungs-Einrichtung so eingerichtet ist, dass sie für Bild-Chips die Positionen des Bild-Chips feststellt, und der Drück-Mechanismus (28) so eingerichtet ist, dass er dann Bewegung zum Drücken nach oben und Bewegung zum Aufnehmen des Bild-Chips durchführt, die Bildverarbeitungs-Einrichtung so eingerichtet ist, dass sie für Nicht-Bild-Chips, die nicht mit der Kamera (42) aufgenommen werden sollen, die Position des Nicht-Bild-Chips unter Bezugnahme auf die erkannte Position des Bild-Chips schätzt, und der Drück-Mechanismus (28) so eingerichtet ist, dass er dann Bewegung zum Drücken nach oben und Bewegung zum Aufnehmen des Nicht-Bild-Chips durchführt.

2. Vorrichtung zum Zuführen von Chips nach Anspruch 1, **dadurch gekennzeichnet, dass** die Bildverarbeitungs-Einrichtung so eingerichtet ist, dass sie auf Basis von Wafer-Zuordnungsdaten, die für Chips (31) auf der Sägefolie (34) "fehlerfrei" oder "fehlerhaft" angeben, fehlerfreie Chips und fehlerhafte Chips bestimmt, wobei der Drück-Mechanismus (28) so eingerichtet ist, dass er dann Bewegung zum Drücken nach oben und Bewegung zum Aufnehmen für fehlerfreie Chips durchführt und für fehlerhafte Chips keine Bewegung zum Drücken nach oben und Bewegung zum Aufnehmen durchführt, und die Bildverarbeitungs-Einrichtung so eingerichtet ist, dass sie für einen fehlerhaften Chip, der der Bild-Chip ist, die Position des fehlerhaften Chips feststellt.

3. Vorrichtung zum Zuführen von Chips nach Anspruch 1 oder 2, **dadurch gekennzeichnet, dass** die Bildverarbeitungs-Einrichtung so eingerichtet ist, dass sie immer dann, wenn die Position des Bild-Chips durch die Bildverarbeitungs-Einrichtung festgestellt wird, die Position des nächsten Bild-Chips unter Bezugnahme auf die Position des Bild-Chips schätzt, wobei die Bildverarbeitungs-Einrichtung so eingerichtet ist, dass sie die Position des Chips durch Aufnehmen der geschätzten Position des Chips als eine Soll-Position feststellt, die durch die Kamera (42) beim Aufnehmen des Bildes des nächsten Chips aufzunehmen ist.

4. Vorrichtung zum Zuführen von Chips nach Anspruch 1, **dadurch gekennzeichnet, dass** die Bildverarbeitungs-Einrichtung so eingerichtet ist, dass sie auf Basis von Wafer-Zuordnungsdaten, die für Chips (31) auf einer Sägefolie (34) "fehlerfrei" oder "fehlerhaft" angeben, fehlerfreie Chips und fehlerhafte Chips bestimmt und Bilder der fehlerhaften Chips mit der Kamera (42) für jeden zweiten Chip oder jeweils einen von mehreren Chips aufnimmt, wenn fehlerhafte Chips in einer vorgegebenen oder einer größeren Menge durchgehend aufeinander folgen, wobei die Bildverarbeitungs-Einrichtung so eingerichtet ist, dass sie Positionen der fehlerhaften Chips feststellt, die Position des nächsten aufzunehmenden Chips unter Bezugnahme auf die Position des fehlerhaften Chips schätzt und die Position des Chips durch Aufnehmen der geschätzten Position des Chips als eine Soll-Position feststellt, die durch die Kamera (42) beim Aufnehmen des Bildes des nächsten Chips aufzunehmen ist.

## Revendications

1. Dispositif de fourniture de dés (11) comprenant
un corps gaufré étendu (30) étiré sur une feuille de découpe en dés étirable (34) sur laquelle est fixée une galette qui a été découpée en dés à diviser en plusieurs dés (31), et une buse d'aspiration (43) pour récupérer un dé (31) sur la feuille de découpe en dés (34),
**caractérisé par** ce qu'il comprend en outre
un mécanisme pousseur (28) pour lever et abaisser une tige pousseuse (39) disposée sous la feuille de découpe en dés (34), qui, lorsqu'il exécute la récupération en abaissant la buse d'aspiration (43) et en récupérant le dé (31) sur la feuille de découpe en dés (34), est adapté pour lever la section adhésive du dé (31) sur la feuille de découpe en dés (34) qui fait l'objet d'une tentative de récupération au moyen de la tige pousseuse (39) pour séparer la section adhésive de dé de la feuille de découpe en dés (34) afin de récupérer le dé (31) sur la feuille de découpe en dés (34) avec la buse d'aspiration (34), et un moyen de traitement d'image qui est adapté pour identifier la position du dé (31) en traitant des images obtenue par une prise d'images du dé (31) sur la feuille de découpe en dés (34) avec une caméra (42), dans lequel les dés-en-image à capturer par la caméra (42) sont spécifiés comme un dé sur deux ou à intervalle de plusieurs dés parmi des dés (31) sur la feuille de découpe en dés (34), dans lequel pour des dés-en-image, le moyen de traitement d'image est adapté pour identifier les positions du dé-en-image, et le mécanisme pousseur (28) est adapté pour alors effectuer un mouvement de poussée et un mouvement de récupération du dé-en-image, dans lequel pour des dés-hors-image à ne pas capturer par la caméra (42), le moyen de traitement d'image est adapté pour estimer la position du dé-hors-image par rapport à la position identifiée du dé-en-image, et le mécanisme de poussée (28) est adapté pour alors effectuer un mouvement de poussée et un mouvement de récupération du dé-hors-image,

2. Le dispositif de fourniture de dés selon la revendication 1, **caractérisé en ce que,** le moyen de traitement d'image est adapté pour déterminer de bons dés et de mauvais dés selon des données cartographiques de galette qui indiquent un bon et un mauvais pour des dés (31) sur la feuille de découpe en dés (34), le mécanisme pousseur (28) étant adapté pour alors effectuer un mouvement de poussée et un mouvement de récupération pour de bons dés et ne pas effectuer de mouvement de poussée et de mouvement de récupération pour de mauvais dés, dans lequel, pour un mauvais dé qui est le dé-en-image, le moyen de traitement d'image est adapté pour identifier la position du mauvais dé.

3. Le dispositif de fourniture de dés selon la revendication 1 ou la revendication 2, **caractérisé en ce que,** le moyen de traitement d'image est adapté pour estimer la position du dé-en-image suivant par rapport à la position du dé-en-image à chaque fois que la position du dé-en-image est identifié e par le moyen de traitement d'image, dans lequel le moyen de traitement d'image est adapté pour identifier la position du dé en capturant la position estimée du dé en tant que position cible à capturer par la caméra (42) lors d'une capture de l'image du dé suivant.

4. Le dispositif de fourniture de dés selon la revendication 1, **caractérisé en ce que** le moyen de traitement d'image est adapté pour déterminer de bons dés et de mauvais dés selon des données cartographiques de galette qui indiquent un bon ou un mauvais pour des dés (31) sur une feuille de découpe en dés (34), et pour capturer des images des mauvais dés par la caméra (42) un dé sur deux ou à intervalle de plusieurs dés lorsque de mauvais dés sont continuellement alignés de manière supérieure ou égale à une quantité spécifiée, dans lequel le moyen de traitement d'image est adapté pour identifier des positions des mauvais dés, pour estimer la position du dé suivant à capturer par rapport à la position du mauvais dé, et pour identifier la position du dé en capturant la position estimée du dé en tant que position cible à capturer par la caméra (42) lors d'une capture de l'image du dé suivant.
